# EUROPÄISCHE PATENTSCHRIFT

(11) **EP 2 317 039 B1**
(45) Veröffentlichungstag und Bekanntmachung des Hinweises auf die Patenterteilung: **25.06.2014**
(21) Anmeldenummer: 10186475.9
(22) Anmeldetag: 05.10.2010
(51) Int. Cl.: E05B 17/22

(54) **Einsteckschloss mit elektrischen Erfassungsmitteln für die Position von Bauteilen**
Mortise lock with electrical means to monitor the position of components
Serrure encastrée avec des moyens électriques pour la détection de la position de composants

(30) Priorität: 27.10.2009 DE 102009046060
(43) Veröffentlichungstag der Anmeldung: 04.05.2011
(73) Patentinhaber: BKS GmbH, 42549 Velbert (DE)
(72) Erfinder: Hennecke, Gerhard, 42555 Velbert (DE); Teubner, Uwe, 42111 Wuppertal (DE); Schoppa, Alfred, 42551 Velbert (DE)
(74) Vertreter: DREISS Patentanwälte PartG mbB

(56) Entgegenhaltungen:
- WO-A1-01/18331
- WO-A1-02/04770
- WO-A1-03/033845
- DE-A1- 4 102 892
- US-A1- 2005 121 224

## Beschreibung

Die Erfindung betrifft ein Einsteckschloss, insbesondere für eine Tür oder ein Fenster, mit Mitteln zur Erfassung der relativen und/oder absoluten Position von beweglichen Bauteilen des Schlosses. Eine Erfassung der Position von Bauteilen von beispielsweise Türschlössern dient dazu, den Zustand des Schlosses und damit den Schließzustand beispielsweise einer Tür zu überwachen. Für die Überwachung der Zustände von Fenstern oder Türen beispielsweise in Gebäuden werden heutzutage verschiedene Systeme und Techniken eingesetzt, damit die Sicherheit gewährleistet werden kann.

Bekannte Einsteckschlösser mit Mitteln zur Erfassung von Zuständen bzw. Positionen der Bauteile sind elektrische Türkontakte, Lichtschranken, Radarsensoren oder eine Infrarotüberwachung. Mehr und mehr werden Schlösser von Gebäuden mit elektrischen Einrichtungen zur Überwachung des Schlosszustands ausgestattet, welche es dem Benutzer oder einem Überwachungspersonal erlauben, detaillierte Informationen über den Zustand von Türen oder Fenstern zu erhalten. Diese Mittel zur Erfassung der Position von Schlossbauteilen dienen insbesondere auch einer Automatisierung der Gebäudeverwaltung.

Die Zustände von Gebäudeschlössern und Informationen hinsichtlich der Positionen der Schlösser sind beispielsweise die Frage, ob ein Riegel vorgeschlossen ist, ob ein Türdrücker an der Innenseite der Tür betätigt wurde, ob ein Schließbart des Schließzylinders im Inneren des Schlosses betätigt wurde, ob ein Fallenriegel oder Schließriegel des Schlosses in einem Schließblech an der Türzarge ganz oder nur teilweise eingerastet ist oder ähnliches. Derartige Informationen hinsichtlich des Zustands von Schlössern wurden bisher im Stand der Technik in der Regel über mechanische Endschalter erfasst, welche im Inneren der mechanischen Konstruktion der Schlösser zwischen den mechanischen Bauteilen untergebracht wurden. Ein Nachteil derartiger mechanischer Positionserfassungsmittel in Schlössern und insbesondere im Fall von Einsteckschlössern liegt darin, dass die mechanischen Endschalter relativ viel Raum für deren Unterbringung innerhalb des Schlosses erfordern. Der erhebliche Platzbedarf von derartigen mechanischen Positionssensoren zwingt die Konstrukteure von Schlössern häufig zu Kompromissen hinsichtlich der Möglichkeiten in der Signalerfassung und der Reihenfolge für die Signalisierung von Zuständen. Des Weiteren erfordern derartige mechanische Positionserfassungsmittel eine Verkabelung der Endsensoren innerhalb des ohnehin vom Platzbedarf sehr begrenzten Gehäuses von Schlössern. Auch lässt sich mit solchen mechanischen Endschaltern meist nur eine begrenzte Anzahl von Zuständen (Endzustände) erfassen, so dass Zwischenzustände hiermit nicht überwacht werden können.

Im Stand der Technik sind auch Einsteckschlösser bekannt, welche mit elektrischen Mitteln zur Erfassung der relativen Lage und Position von Bauteilen und damit des Zustands des Schlosses versehen sind: In dem deutschen Gebrauchsmuster DE 89 07 141 ist beispielsweise ein Einsteckschloss mit einem eingebauten Kontakthalter beschrieben, das mit einer elektrischen Zustandsüberwachung der Schließteile, wie des Schließriegels, des Fallenriegels oder ähnlichem, ausgestattet ist. Bei diesem bekannten Einsteckschloss wird über einen Reedkontakt ein Positionssignal erzeugt, wobei der Reedkontakt in einer extra Aufnahmerinne in einem Kontakthalter untergebracht ist und mit einem Überwachungskabel, das aus dem Schloss herausgeführt ist, mit einer externen Überwachungseinrichtung verbunden wird. Das Vorsehen einer länglichen Aufnahmerinne innerhalb des Gehäuses des Schlosses und die hier notwendige Verkabelung erfordern relativ viel zusätzlichen Raum im Inneren des Schlosses, so dass neben den mechanischen Bauteilen des Schlosses ausreichend Platz für diese elektrische Überwachungseinrichtung vorhanden sein muss.

Aus der WO 01/18331 A1 ist ein Schließsystem bekannt, welches zur Erfassung der Lage von Teilen des Schließsystems magnetische Sensoren verwendet.

Ausgehend von der WO 01/18331 A1 ist es die Aufgabe der vorliegenden Erfindung, ein Einsteckschloss mit einer verbesserten Überwachungsmöglichkeit des Zustands des Schlosses bereitzustellen, welche mit möglichst geringem Platzbedarf in die Schlösser integriert werden kann. Diese Aufgabe wird mit einem Einsteckschloss mit den Merkmalen des Anspruchs 1 gelöst. Vorteilhafte Ausgestaltungen und Weiterbildungen sind Gegenstand der abhängigen Ansprüche.

Das erfindungsgemäße Einsteckschloss weist Mittel zur Erfassung der relativen und/oder absoluten Position von beweglichen Bauteilen des Schlosses und damit der jeweiligen Schlosszustände auf, wobei mindestens ein erstes plattenförmiges Bauteil und mindestens ein zweites, relativ zu dem ersten Bauteil verstellbares Bauteil vorgesehen ist, welche jeweils oder mindestens eines von ihnen verschiedene Positionen je nach der Funktion des Schlosses einnehmen können, wobei die Mittel zur Erfassung der Position mindestens einen magnetosensitiven Sensor aufweisen, welcher in einem der Bauteile des Schlosses eingebaut ist und dessen Kontakte direkt mit einer Leiterplatte oder einer Leiterfolie verbunden sind, und dass der Sensor mit mindestens einem Magneten an einem relativ zu ihm beweglichen anderen Bauteil zur Erzeugung von Positionssignalen zusammenwirkt, das Einsteckschloss nach der Erfindung ist **dadurch gekennzeichnet,** dass das erste plattenförmige Bauteil einen Durchbruch aufweist, in welchem der Sensor versenkt montiert ist und dass das zweite Bauteil einen Durchbruch aufweist, in welchem der Magnet versenkt montiert ist. Damit können die Mittel zur (elektrischen) Erfassung der Position von Bauteilen sehr platzsparend integriert werden und müssen nicht mehr zwischen den mechanischen Bauteilen und Konstruktionselementen des Schlosses untergebracht werden, sondern können beispielsweise seitlich von diesen angeordnet werden. Die Verwendung eines magnetosensitiven Sensors, der in einem der Bauteile eingebaut ist, vermeidet einen zusätzlichen Platzbedarf für die Sensorik. Dadurch, dass die Kontakte des mindestens einen magnetosensitiven Sensors direkt in der Leiterplatte versenkt oder mit einer Leiterfolie verbunden sind, ist keine Verkabelung mehr zum Anschließen des Sensors erforderlich, was ebenfalls den Raumbedarf für die Positionserfassungsmittel reduziert. Der mindestens eine magnetosensitive Sensor nach der Erfindung kann in einem mechanischen Bauteil des Einsteckschlosses, wie in einem Riegel, einem Betätigungsorgan oder ähnlichem, eingebaut sein oder alternativ in einer elektrischen Leiterplatte seitlich von der eigentlichen Schlossmechanik. In letzterem Fall wird eine Beeinträchtigung der mechanischen Funktionen des Schlosses sicher vermieden, und eine sehr genaue Positionserfassung der Bauteile wird hierdurch möglich. Der magnetosensitive Sensor nach der Erfindung, welcher beispielsweise ein Reedschalter oder ein Hall-Sensor sein kann, wirkt erfindungsgemäß mit mindestens einem Magneten zusammen, der relativ zu dem Sensor beweglich eingebaut ist. Die Erfassung der Position des Magneten oder der Mehrzahl an Magneten erlaubt eine Erzeugung eines Positionssignals, sobald sich der Magnet beispielsweise auf Höhe des Sensors und damit in Überlappung befindet.

Die relative Beweglichkeit zwischen dem magnetosensitiven Sensor und den Magneten kann an verschiedenen Bauteilen realisiert werden, wie zum Beispiel an einem Fallenriegel, einem Schließriegel, einem Schließzylinder oder an einer Drückernuss. Die relative Bewegung zwischen dem magnetosensitiven Sensor nach der Erfindung und dem Magneten an einem anderen Bauteil des Schlosses kann eine Längsbewegung, eine Querbewegung, eine Rotationsbewegung oder ähnliches sein. Wenn mehrere Magnete an ein und demselben Bauteil oder alternativ mehrere Sensoren bezüglich diesem Bauteil montiert sind, können mit dem erfindungsgemäßen Einsteckschloss verschiedenste Positionssituationen erfasst und überwacht werden, wie zum Beispiel ein völlig eingezogener Fallenriegel, ein Fallenriegel in ausgefahrener Fallenstellung und ein vollständig ausgefahrener Fallenriegel in Schließstellung.

Neben dem gegenüber dem Stand der Technik deutlich verringerten Platzbedarf für die Positionserfassungsmittel und der dadurch geringeren Baugröße der Einsteckschlösser hat das erfindungsgemäße Einsteckschloss auch den Vorteil einer leichteren Montage der separat von der Schlossmechanik aufgebauten Erfassungsmittel. Die Trennung zwischen mechanischen Bauteilen und elektrischen Positionserfassungsmitteln hat außerdem den Vorteil, dass eine sehr genaue Platzierung der Sensoren und Magnete relativ zu der Schlossmechanik ermöglicht wird, was die Erfassungsgenauigkeit erhöht. Nicht zuletzt wird mit dem erfindungsgemäßen Einsteckschloss eine Störung aufgrund von Verschmutzung oder Beschädigung der Sensoren und elektrischen Bauteile effektiv vermieden, so dass eine langfristige und sichere Funktion des Einsteckschlosses mit einem Zustandsüberwachungssystem gewährleistet ist.

Bei dem erfindungsgemäßen Einsteckschloss ist das mindestens eine plattenförmige Bauteil des Schlosses mit einem Durchbruch versehen, in welchem der magnetosensitive Sensor versenkt montiert ist. Der Durchbruch kann auf die Größe des Sensors angepasst sein. Durch die Montage des Sensors versenkt innerhalb des plattenförmigen Bauteils wird der Platzbedarf weiter verringert, da sich der Sensor zumindest weitestgehend innerhalb der Dicke des plattenförmigen Bauteils befindet.

Nach einer weiteren vorteilhaften Ausgestaltung der Erfindung ist das plattenförmige Bauteil eine (elektrische) Leiterplatte, und die Kontakte des Sensors sind direkt mit der Leiterplatte verbunden. In diesem Fall sind keinerlei Verkabelungen für den Anschluss des Sensors erforderlich, da sich die Kontakte direkt an einer Leiterplatte befinden und mit dieser einfach beispielsweise durch Verlöten verbunden werden können.

Nach der Erfindung ist der mindestens eine Magnet, welcher mit dem Sensor zusammenwirkt, in einem Bauteil des Schlosses selbst versenkt eingebaut. Der Magnet oder die Mehrzahl von beispielsweise in Reihe angeordneten Magneten kann in plattenförmigen mechanischen Bauteilen des Schlosses, wie in einem Mitnehmerarm zur Verstellung eines Fallenriegels, eingebaut werden. Die Magnete für die Erfassungsmittel können jedoch auch in anderen, nicht-plattenförmigen Bauteilen, wie in einem Riegel selbst, einer Drückernuss oder ähnlichem, montiert werden. Dies hat den Vorteil, dass lediglich der magnetosensitive Sensor und die Magnete für die Realisierung des Überwachungssystems nach der Erfindung erforderlich sind und keine zusätzlichen Halteelemente eingebaut werden müssen. Wenn Bauteile des Schlosses beispielsweise aus Kunststoffmaterial realisiert sind, können die Magnete für die Erfassung der Position der Bauteile direkt ohne zusätzliche Halterungen in das Material der Bauteile, beispielsweise durch Pressen, eingesetzt werden.

Nach einer weiteren vorteilhaften Ausgestaltung des erfindungsgemäßen Einsteckschlosses ist der magnetosensitive Sensor als ein gekapselter Sensor in SMD-Bauweise aufgebaut. Die gekapselte Konstruktion eines magnetosensitiven Sensors hat den Vorteil, dass dieser vor Beschädigung und Verschmutzung gut geschützt ist. Eine gekapselte SMD-Bauweise (Abk. für Surface-Mounted Device, zu Deutsch: oberflächenmontierbares Bauelement) ist eine aus der Elektrotechnik dem Fachmann hinlänglich bekannte Konstruktionsart für elektronische Bauelemente. Die gekapselte Bauform ist in sich geschlossen und weist lediglich vorragende Anschlusskontakte auf, die direkt an beispielsweise einer Leiterplatte verlötet werden können. Statt auf einer Oberfläche einer Platine montiert zu werden, wird der magnetosensitive Sensor erfindungsgemäß in SMD-Bauweise jedoch in ein Bauteil eingebaut, d. h. in eine Ausnehmung, eine Bohrung oder ähnliches eingesetzt und fixiert, und dann mit den Anschlusskontakten für die Weiterleitung der erfassten Signale beispielsweise über Leiterbahnen einer Platine verlötet.

Nach einer weiteren vorteilhaften Ausgestaltung der Erfindung weist das Bauteil zur Aufnahme des Sensors einen Durchbruch auf, welcher/welche geringfügig größer ist als die Außenabmessung des Sensors selbst. Das relativ bewegbare Bauteil des Einsteckschlosses kann, wenn es ein plattenförmiges Bauteil ist, mit einem Durchbruch oder einer durchgehenden Bohrung versehen sein, in welche der Magnet vorteilhafterweise eingesetzt werden kann. Wenn es ein dickeres Bauteil ist, kann es mit einem Sackloch oder mit einer Ausnehmung realisiert werden, so dass auch in diesem Fall der Magnet mit möglichst geringem (zusätzlichem) Platzbedarf in die bestehenden Konstruktionselemente des Schlosses integriert werden kann. Durch die geringfügig größere Abmessung des Durchbruchs ist auch eine relativ einfache Montage des Sensors gewährleistet, indem er beispielsweise über eine Kunststoffhalterung oder ähnliches in die dafür etwas größere Öffnung oder den Durchbruch eingebracht wird. Andere Mittel zur Montage von Bauteilen des Schlosses in einem Durchbruch oder in einem Loch können ebenfalls im Rahmen der Erfindung verwendet werden, wie zum Beispiel eine Klebung, eine Verkrimpung, eine Verschraubung oder ähnliches.

Nach einer weiteren vorteilhaften Ausgestaltung der Erfindung ist der Magnet oder sind die Magnete der Erfassungsmittel des Einsteckschlosses mit möglichst geringem Abstand unter einem plattenförmigen Bauteil, insbesondere einer elektrischen Platine, angeordnet. Die Erfassungsgenauigkeit der Position der Bauteile wird hierdurch noch weiter verbessert. Durch den mit möglichst geringem Abstand zwischen dem Magneten und der Platinenunterseite wird eine hohe Präzision in der Positionserfassung gewährleistet. Außerdem ist durch den geringem Abstand des Magneten bezüglich des plattenförmigen Bauteils der Raumbedarf für die Unterbringung der Mittel zur Erfassung der Position von Bauteilen des Schlosses weiter verringert, weil es nicht mehr möglich ist, durch zu geringem Abstand zum Sensor diesen durch Berührung zu beschädigen oder abzureißen.

Nach einer weiteren vorteilhaften Ausgestaltung der Erfindung sind mehrere Sensoren in einer Reihenanordnung vorgesehen zur Erfassung von mehreren möglichen relativen Positionen der Bauteile zueinander. Hierdurch lassen sich präzise auch Zwischenstellungen mit der Erfindung erfassen, und eine lückenlose Überwachung des Schlosszustands wird ermöglicht. Eine Anordnung in einer Reihe kann eine geradlinige Reihe oder eine auf einer Kurvenbahn liegende Reihe von Sensoren umfassen, ohne den Rahmen der vorliegenden Erfindung zu verlassen. Eine Anordnung der Sensoren in einer Reihe auf einer Kurvenbahn ist beispielsweise vorteilhaft, wenn eine Rotationsbewegung, wie die Stellung des Schließbartes eines Schließzylinders oder der Drückernuss einer Klinke, mit der Erfindung überwacht werden soll. Damit sind nicht nur Endstellungen von beweglichen Bauteilen und von Schlössern erfassbar, sondern die Erfindung ermöglicht eine Vielzahl von verschiedenen Überwachungssituationen, und dies in einer hohen Präzision und bei relativ geringem Bauaufwand. Alternativ hierzu kann auch eine Mehrzahl von in Reihe angeordneten Magneten an einem Bauteil vorgesehen sein, welche mit einem Sensor zur Positionssignalerzeugung zusammenwirken.

Nach einer weiteren vorteilhaften Ausgestaltung der Erfindung ist das mindestens eine plattenförmige Bauteil des Einsteckschlosses eine elektrische Platine, welche oberhalb oder unterhalb der mechanischen Bauteile des Schlosses positioniert ist. Durch die Positionierung der Platine oberhalb oder unterhalb der mechanischen Bauteile kann eine präzise Erfassung der Positionen der mechanischen Bauteile gewährleistet werden aufgrund der Nähe zu diesen, und trotzdem sind die (elektrischen) Bauelemente von der eigentlichen Schlossmechanik separat angeordnet, so dass Probleme aufgrund einer Beschädigung oder Verschmutzung durch die mechanischen Bauteile sicher vermieden werden. Außerdem ermöglicht dies eine erleichterte Reparatur im Falle eines Ausfalls eines oder mehrerer Elemente der Erfassungsmittel. Die elektrische Platine oberhalb oder unterhalb der Schlossmechanik kann leicht von außen zugänglich eingebaut werden, so dass sie auch entsprechend gut ausgetauscht werden kann.

Nach einer diesbezüglichen vorteilhaften Alternative der Erfindung ist die elektrische Platine teilweise freigeschnitten. Dort, wo keine elektrischen Bauteile wie ein magnetosensitiver Sensor, Leiterbahnen oder ähnliches erforderlich sind, ist die Platine mit Aussparungen und Ausnehmungen versehen, so dass die notwendigen Durchgriffe der mechanischen Bauteile hier realisiert werden können. Nach einer diesbezüglichen weiteren vorteilhaften Alternative des erfindungsgemäßen Einsteckschlosses bildet die elektrische Platine einen Boden oder eine Decke des Schlosses selbst. Auf diese Weise können die Baugröße und insbesondere die Dicke des Einsteckschlosses weiter verringert werden, so dass es trotz dieser zusätzlichen Funktionalitäten auch in relativ dünnen Türen oder Fenstern eingebaut und steckend montiert werden kann.

Weitere Vorteile, Merkmale und Einzelheiten der Erfindung ergeben sich aus den Unteransprüchen sowie der nachfolgenden Beschreibung, in der unter Bezugnahme auf die Zeichnung besonders bevorzugte Ausführungsbeispiele im Einzelnen beschrieben sind.

In der Zeichnung zeigen:
- Fig. 1: eine ausschnittsweise Draufsicht eines ersten Ausführungsbeispiels eines erfindungsgemäßen Einsteckschlosses mit Fallenriegel;
- Fig. 2a bis 2c: eine perspektivische Ansicht, eine Seitenansicht und eine Draufsicht eines zweiten Ausführungsbeispiels der Erfindung, wobei nur zur Veranschaulichung des Funktionsprinzips des magnetosensitiven Sensors die Elemente des Sensors ausschnittsweise in einer unbetätigten Stellung des Sensors gezeigt sind;
- Fig. 3a bis 3c: entsprechende Ansichten des Ausführungsbei- spiels der Fig. 2a bis 2c, wobei der Sensor hier in der betätigten Stellung gezeigt ist;
- Fig. 4: eine Schnittansicht gemäß A-A aus Fig. 3c auf Höhe des erfindungsgemäßen Sensors; und
- Fig. 5: eine vergrößerte Schnittdetailansicht aus Fig. 4, welche die Halterung eines erfindungsgemäßen Magneten in einem Durchbruch eines plattenförmigen Bauteils zeigt.

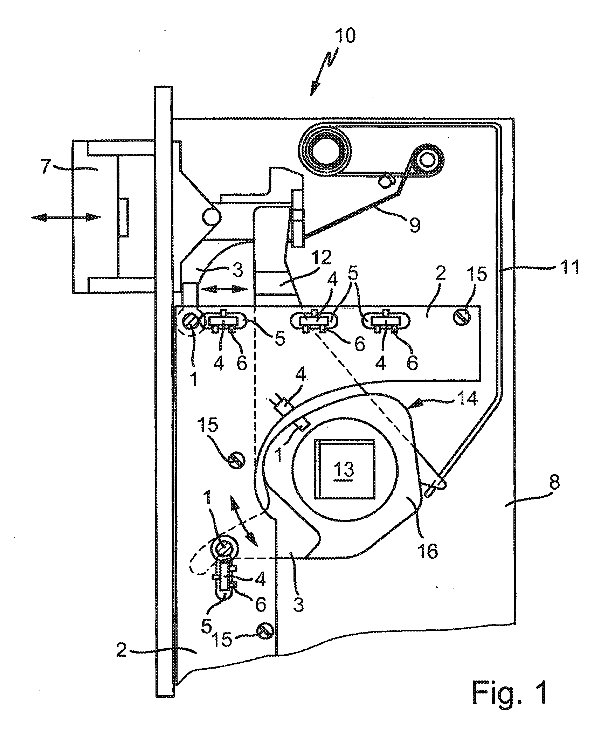

Die Fig. 1 zeigt ausschnittsweise in einer Draufsicht ein erstes Ausführungsbeispiel eines erfindungsgemäßen Einsteckschlosses mit Mitteln zur Erfassung der relativen Position der Schlossbauteile. In der Fig. 1 ist nur der obere Teil des Einsteckschlosses gezeigt, in welchem der Fallenriegel 7 linker Hand zu erkennen ist und in welchem sich die für die Erfindung relevanten Mittel zur Erfassung der Position von Schlossbauteilen befinden. Das Schloss ist bei diesem Ausführungsbeispiel ein Einsteckschloss mit lediglich einem Fallenriegel 7. Es kann jedoch neben dem Fallenriegel 7 auch noch einen oder mehrere Schließriegel aufweisen. Der Fallenriegel 7 ist aus dem Gehäuse 8 des Einsteckschlosses 10 herausgedrückt und kann gegen eine Feder 9 im Inneren des Gehäuses 8 bis in eine völlig eingezogene Position hineingedrückt werden, wie dies dem Fachmann des Gebiets hinlänglich bekannt ist.

Im Inneren des Gehäuses 8 des Einsteckschlosses 10 ist ein Mitnehmer 12 mit dem rückwärtigen Ende des Fallenriegels 7 in Kontakt, welcher Mitnehmer 12 wiederum mit einer Drückernuss 16 verbunden ist, so dass über eine (in Fig. 1 nicht dargestellte) Klinke in einem Vierkantdurchbruch 13 des Schlosses 10 der Riegel 7 beispielsweise von der Innenseite der Tür her geöffnet werden kann. Die Drückernuss 16 ist wiederum über eine Rückstellfeder 11 federbelastet, so dass sie sich bei Loslassen der Klinke in die in der Fig. 1 dargestellte Ausgangslage zurückstellt, in welcher der Fallenriegel 7 ausgefahren ist, d. h. vollständig aus dem Gehäuse 8 vorragt, und über ein Schließblech am Rahmen die Tür oder das Fenster verschließt. Beim Öffnen des Einsteckschlosses 10 führt also der Fallenriegel 7 eine Querverschiebung in horizontaler Richtung ins Innere des Gehäuses 8 aus, während die Drückernuss 16 eine Drehbewegung um eine Drehachse im Zentrum des Vierkantdurchbruchs 13 ausführt. An dem der Rückstellfeder 11 abgewandten Ende der Drückernuss 16 ist ein Vorsprung gebildet, der sich unterhalb eines plattenförmigen Bauteils 2 erstreckt. In diesem Vorsprung der Drückernuss 16 ist ein Magnet 1 eingebaut, der sich zusammen mit der Rotationsbewegung der Klinke und der Drückernuss 16 auf einer Kreisbahn unterhalb des plattenförmigen Bauteils 2 bewegt, wie dies in der Fig. 1 mit dem Drehpfeil angedeutet ist. Dieser Magnet 1 dient nach der Erfindung zusammen mit einem magnetosensitiven Sensor 4 der Erzeugung von Positionssignalen für die Erfassung der relativen Lage der Bauteile zueinander und damit der Feststellung des Zustands des Einsteckschlosses 10. Bei diesem Ausführungsbeispiel der Erfindung, wie es in der Fig. 1 schematisch dargestellt ist, ist hierzu in einem oberen plattenförmigen Bauteil 2 ein Durchbruch 5 vorhanden, der in der Größe so abgestimmt ist, dass der Sensor 4 dort eingesteckt und montiert werden kann. Der magnetosensitive Sensor 4, welcher beispielsweise als ein Hall-Sensor oder ein Reedschalter ausgeführt sein kann, wirkt mit dem sich direkt darunter bewegenden Magneten 1 zusammen, der ein Anzeiger für die Drehstellung der Drückernuss 16 ist. Befindet sich der Magnet 1 auf Höhe des Sensors 4, wird ein Signal erzeugt. Befindet er sich nicht auf Höhe des Sensors 4, wird kein Signal erzeugt.

Zur Erfassung der genauen Position des Fallenriegels 7 sind nach dem Beispiel der Fig. 1 am oberen Ende des plattenförmigen Bauteils 2 drei weitere magnetosensitive Sensoren 4 eingebaut. Diese drei Sensoren 4 sind ebenfalls in entsprechenden Durchbrüchen 5 in dem plattenförmigen Bauteil 2, wie beispielsweise einer elektrischen Leiterplatte, eingesetzt und über eine Halterung 6, beispielsweise durch Klemmung, fest montiert. Das plattenförmige Bauteil 2 ist relativ zu dem Gehäuse 8 über Befestigungsschrauben 15 fest montiert. Alternativ könnte jedoch auch das plattenförmige Bauteil ein bewegliches Teil des Schlosses 10 sein. Der Magnet 1 am unteren Vorsprung des Fallenriegels 7 bewegt sich zusammen mit dem Fallenriegel 7 in Richtung der Reihenanordnung der drei Sensoren 4, so dass jeweils bei Zusammentreffen eines Sensors 4 mit dem darunter sich hin- und herbewegenden Magneten 1 ein Signal erzeugt wird, das die verschiedenen Positionen des Fallenriegels 7 anzeigt. Im Beispiel der Fig. 1 befindet sich der Magnet 1 des Fallenriegels 7 annähernd auf Höhe des linken Sensors 4, so dass eine Schließstellung angezeigt werden würde. Aus Gründen der zeichnerischen Übersichtlichkeit sind in der Fig. 1 die Sensoren 4 nicht vollständig überlappend mit den Magneten 1 eingezeichnet, sondern leicht versetzt zu diesen.

Die Funktionalität des Positionserfassungssystems mit mindestens einem Magnet-Sensor und Magneten wird jedoch auch noch anhand der nachfolgenden Figuren näher beschrieben werden. Wenn sich der Magnet 1 des darunter beweglich montierten Bauteils 3, in diesem Beispiel des Fallenriegels 7, nach rechts bewegt und auf Höhe des mittleren Sensors 4 ankommt, zeigt dies beispielsweise eine Zwischenstellung an. Wenn der Magnet 1 des Fallenriegels 7 auf Höhe des rechten Sensors 4 ankommt, zeigt dies eine vollständig eingezogene Position des Fallenriegels 7 und damit einen Öffnungszustand des Einsteckschlosses 10 an. Das plattenförmige Bauteil 2 ist in diesem Ausführungsbeispiel eine elektrische Leiterplatte, die sich oberhalb der mechanischen Elemente des Einsteckschlosses 10 befindet. Die Leiterplatte 2 weist eine halbkreisförmige Ausnehmung 14 in dem Bereich des Vierkantdurchbruchs 13 auf, so dass die Drehbewegung der Drückernuss 16 und das Hindurchführen eines Vierkants der Klinke in den Vierkantdurchbruch 13 nicht behindert werden. Die Leiterplatte weist Leiterbahnen auf, die durch Isolierabschnitte voneinander elektrisch getrennt sind, wie dies bei elektrischen Leiterplatten (Platinen) üblicherweise der Fall ist. Mittels dieser Leiterbahnen (aus Veranschaulichungsgründen in Fig. 1 nicht eingezeichnet) dient erfindungsgemäß die Platine 2 vorzugsweise auch für den direkten Anschluss der Kontakte der Sensoren 4, so dass eine bisher übliche Verkabelung derartiger Magnet-Sensoren innerhalb des ohnehin sehr beengten Raums des Gehäuses 8 des Einsteckschlosses 10 nicht erforderlich ist. Die in den Durchbrüchen 5 oder Bohrungen versenkten Sensoren 4 haben nicht nur im Hinblick auf die vereinfachte

Anschlussmöglichkeit mit Signalleitungen einen Vorteil, sondern auch in Bezug auf den erforderlichen Raumbedarf. Da sich die Sensoren 4 fast vollständig innerhalb der Durchbrüche 5 befinden und dort beispielsweise über eine Kunststoffklemmhalterung 6 gehalten werden, wird durch die Sensoren 4 die Bauhöhe nicht unnötig vergrößert, und es kann auf sehr geringem Raum eine präzise Positionssensorik für eines oder mehrere mechanische Bauteile in das Schloss integriert werden, ohne einen großen zusätzlichen Aufwand zu betreiben. Da sich das plattenförmige Bauteil 2, d. h. in diesem Fall die elektrische Platine, direkt oberhalb der mechanischen beweglichen Bauteile der Schlosskonstruktion befindet, kann eine sehr genaue und vorzugsweise berührungslose Erfassung der relativen Lage der einzelnen Bauteile durchgeführt werden und damit eine sehr genaue Überwachung der Zustände des Einsteckschlosses 10 erfolgen. Die Möglichkeiten einer Überwachung der Position von mechanischen Bauteilen sind dabei vielseitig. Es können Längs-und Querverschiebungen, Drehbewegungen, Zwischenpositionen und EndPositionen gleichermaßen erfasst werden, ohne dass dazu ein größerer Umbau des Schlosses notwendig ist und ohne dass hierfür ein vergrößertes Gehäuse 8 erforderlich wäre.

Die sich unter der Platine 2 hin- und herbewegenden Magnete 1 an den beweglichen Bauteilen 3 des Einsteckschlosses 10 sind nach der Erfindung vorzugsweise berührungslos. Die Magnete 1 können jedoch auch so nahe an der Unterseite des plattenförmigen Bauteils 2 angebracht sein, dass sie schleifend an der Unterseite entlanggleiten und direkt mit den Sensoren 4 in Kontakt gelangen. In diesem Fall sind die Magnete 1 vorzugsweise in Richtung zu der Unterseite der Platine 2 federbelastet. Bei diesem Ausführungsbeispiel sind die Sensoren 4 jeweils in entsprechend großen Ausnehmungen bzw. Durchbrüchen 5 in der Platine 2 eingebaut. Sie können jedoch auch ebenso bei dickeren Bauteilen in entsprechenden Ausnehmungen und Sack-Bohrungen eingesetzt sein, beispielsweise wenn sie in einem der beweglichen Teile der Schlossmechanik direkt eingesetzt sind. In diesem Fall wären die Magnete 1 als feststehende Elemente realisiert, während sich die magnetosensitiven Sensoren 4 in den beweglichen Teilen befinden würden. Erfindungsgemäß kommt es nur auf eine relative Bewegung zwischen den mindestens zwei Bauteilen 2, 3 des Schlosses an. Da mit der erfindungsgemäßen Lösung eine weitestgehende Trennung der mechanischen Elemente des Einsteckschlosses 10 und der magneto-elektrischen Mittel 2, 4 zur Erfassung der Relativbewegungen der Bauteile vorgesehen ist, ist das Erfassungssystem relativ unanfällig gegenüber Beschädigungen, Verschmutzungen und fehlerhaften Detektionen aufgrund von Fehlmontagen.

Die hier dargestellten, vollständig auf einer Seite montierten Sensoren 4 an ein und derselben Platine 2 sind von außen leicht zugänglich und können ohne weiteres repariert oder ausgetauscht werden. Eine Fehlerfassung der Positionen der mechanischen Bauteile wird weitestgehend vermieden, da die Platine 2 und die Durchbrüche 5 in sehr geringen Fertigungstoleranzen hergestellt werden können und die Platine über die Befestigungsschrauben 15 sehr genau im Verhältnis zum Gehäuse 8 montiert werden kann. Nicht zuletzt vereinfacht die oberhalb der mechanischen Bauteile liegende Erfassung der Positionen über die Sensoren 4 in Durchbrüchen 5 der Platine 2 die Montage des Einsteckschlosses 10. Der größte Vorteil der Erfindung liegt in dem verringerten Raumbedarf der zusätzlichen notwendigen Bauteile für die Erfassung der Positionen der beweglichen Schlossbauteile 3. Die Erfassungsmittel können wenig dicker als die Dicke des plattenförmigen Bauteils 2 selbst sein, das hier in Form einer elektrischen Leiterplatte realisiert ist, jedoch ebenso ein anderes plattenförmiges Bauteil des Schlosses selbst sein kann. Nach letzterem Aspekt kann das plattenförmige Bauteil 2 die Außenwand des Gehäuses 8 selbst bilden und beispielsweise eine untere oder eine obere Wand des Gehäuses 8 darstellen oder bilden. Ebenso kann anstatt einer elektrischen Platine 2 eine Leiterfolie verwendet werden, um den weitestgehend kabellosen Anschluss der magnetosensitiven Sensoren 4 innerhalb des Einsteckschlosses 10 zu ermöglichen. Eine Leiterfolie benötigt relativ wenig Platz, und in diesem Fall können die Sensoren 4 gemäß der Erfindung auch in die bestehenden Bauteile des Einsteckschlosses 10 direkt eingesetzt und integriert werden.

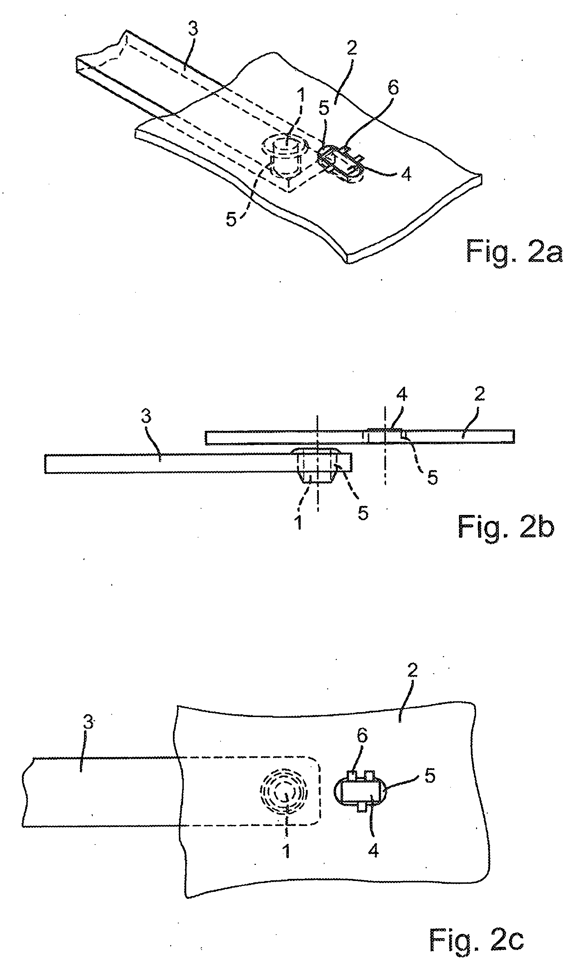

In den Fig. 2a bis 2c sind zur Veranschaulichung des Funktionsprinzips der Erfassung der Position von relativ zueinander beweglichen Bauteilen eines Schlosses ausschnittsweise der magnetosensitive Sensor 4 und der Magnet 1 in einer schematischen Ansicht, einer Seitenansicht und einer Draufsicht als Detail dargestellt. In den Fig. 2a bis 2c befindet sich der in dem Bauteil 3 eingebaute Magnet 1 unterhalb des Bauteils 2 linker Hand verschoben zu dem magnetosensitiven Sensor 4, der wiederum in einem Durchbruch 5 des Bauteils 2 eingesetzt und dort befestigt ist. Diese relative Lage des Magneten 1 zu dem Sensor 4 erzeugt kein Signal im Sensor 4 und kennzeichnet somit die unbetätigte Position des Sensors.

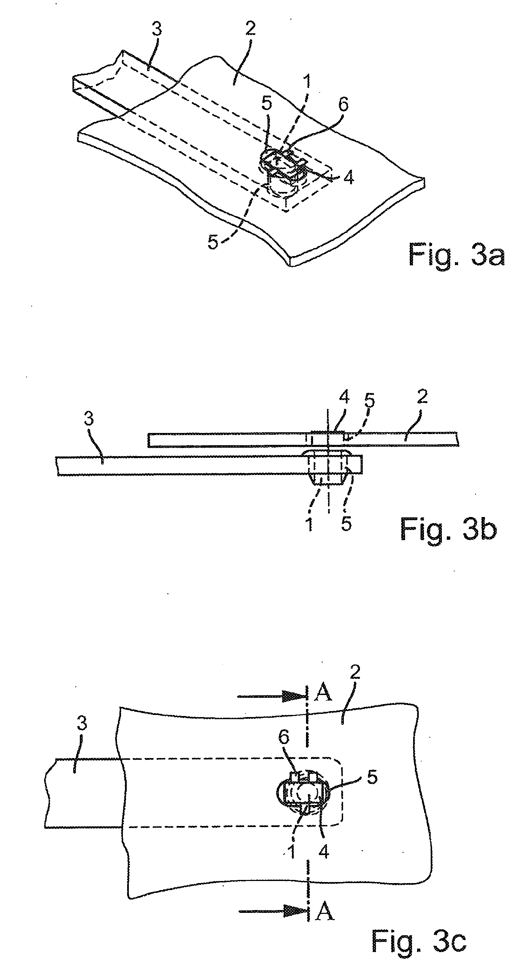

In den entsprechenden Fig. 3a bis 3c ist hingegen die betätigte Position des Magnet-Sensors 1, 4 gezeigt. Im Vergleich zu den Fig. 2a bis 2c ist nun der Magnet 1 direkt unterhalb des Sensors 4, d. h. das Bauteil 3 und das Bauteil 2 haben sich aufeinander zu bewegt - oder wenigstens eines von ihnen. Dies erzeugt in dem Sensor 4 ein elektrisches Signal, so dass der Magnet-Sensor betätigt ist. Das Signal, das im Sensor 4 erfasst wird, wird über die Kontakte des Sensors 4 (in den Figuren nicht zu erkennen) direkt an eine Leiterplatte 2 gegeben, über welche es der entsprechenden Überwachungselektronik zugeführt wird. Wie es insbesondere in der Seitenansicht der Fig. 3 gut zu erkennen ist, ragt der Sensor 4 kaum über die Oberfläche des plattenförmigen Bauteils 2 hinaus, er ist sozusagen fast vollständig in die Dicke des Bauteils 2 eingesetzt. Ebenso ist der Magnet 1 in dem unteren Bauteil 3 des Schlosses fast vollständig eingesetzt. Beide sind über entsprechende Halterungen 6 in dem jeweiligen Durchbruch 5 fixiert und befestigt. Der Sensor 4 und der Magnet 1 können auch über andere Techniken an den Bauteilen 2, 3 des Einsteckschlosses 10 montiert und befestigt werden, wie sie dem Fachmann des Gebiets bekannt sind.

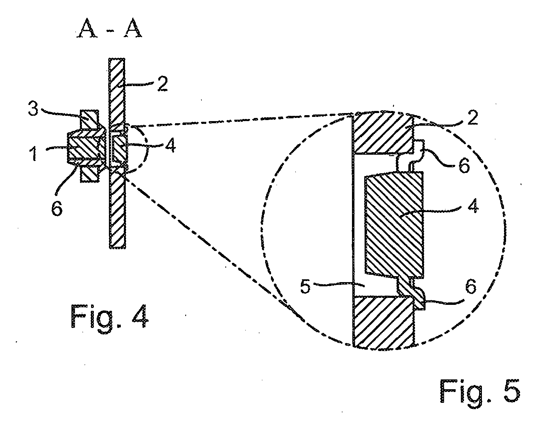

In der Fig. 4 ist eine Schnittansicht gemäß A-A aus Fig. 3c wiedergegeben, aus welcher die Halterung 6 des magnetosensitiven Sensors 4 genauer zu erkennen ist, und zwar im Zusammenhang mit der vergrößerten Detailansicht der Fig. 5. Der Kunststoffhalter 6 des Magnet-Sensors 4 besteht bei diesem Ausführungsbeispiel aus einem Haltering und seitlich vorragenden Armen aus Kunststoff, die in der Dicke derart bemessen sind, dass sie in den entsprechend etwas größeren Durchbruch 5 in dem plattenförmigen Bauteil durch Klemmen oder Pressen eingesetzt werden können. Alternativ hierzu kann der Sensor 4 ebenso wie der Magnet 1 beispielsweise auch durch ein Verkleben in den jeweiligen Bauteilen 2, 3 integriert und fixiert werden. Auch sind andere Montagemethoden, wie eine Crimp-Verbindung, eine Schraubverbindung oder ähnliches, im Rahmen der vorliegenden Erfindung denkbar.

Der wesentliche Vorteil der Erfindung wird darin gesehen, dass aufgrund der hängenden oder versenkten Einbaulage, das Sensorbauteil nicht mehr durch das vorbeibewegte Magnetbauteil beschädigt werden kann. Dies ist bei konventioneller SMD-Bestückung nur mit ausreichendem Abstand zwischen Magnet und Sensor sicher zu stellen.

## Patentansprüche

1. Einsteckschloss (10) für insbesondere eine Tür oder ein Fenster mit Mitteln zur Erfassung der relativen und/oder absoluten Position von beweglichen Bauteilen des Schlosses (10) mit mindestens einem ersten plattenförmigen Bauteil (2) und mindestens einem relativ zum ersten Bauteil (2) verstellbaren zweiten Bauteil (3), welche verschiedene Positionen je nach Funktion des Schlosses (10) einnehmen können, wobei die Mittel zur Erfassung der Position mindestens einen magnetosensitiven Sensor (4) aufweisen, welcher in einem der Bauteile (2, 3) eingebaut ist und dessen Kontakte direkt mit einer Leiterplatte oder einer Leiterfolie verbunden sind, und wobei der Sensor (4) mit mindestens einem Magneten (1) an einem relativ dazu beweglichen anderen Bauteil (2, 3) zur Erzeugung eines Positionssignals zusammenwirkt, **dadurch gekennzeichnet, dass** das erste plattenförmige Bauteil (2) einen Durchbruch (5) aufweist, in welchem der Sensor (4) versenkt montiert ist und dass das zweite Bauteil (3) einen Durchbruch (5) aufweist, in welchem der Magnet (1) versenkt montiert ist.

2. Einsteckschloss nach Anspruch 1, **dadurch gekennzeichnet, dass** das plattenförmige Bauteil (2) eine Leiterplatte ist und dass die Kontakte des Sensors (4) direkt mit der Leiterplatte verbunden sind.

3. Einsteckschloss nach einem der vorhergehenden Ansprüche, **dadurch gekennzeichnet, dass** der mindestens eine Magnet (1) in einem Bauteil (3) des Schlosses (10) versenkt eingebaut ist und mit möglichst geringem Abstand unter dem plattenförmigen Bauteil (2), insbesondere einer elektrischen Platine, angeordnet ist.

4. Einsteckschloss nach einem der vorhergehenden Ansprüche, **dadurch gekennzeichnet, dass** der magnetosensitive Sensor (4) als ein gekapselter Sensor in SMD-Bauweise aufgebaut ist.

5. Einsteckschloss nach einem der vorhergehenden Ansprüche, **dadurch gekennzeichnet, dass** das plattenförmige Bauteil (2) zur Aufnahme des Sensors (4) einen Durchbruch (5) aufweist, welcher geringfügig kleiner oder größer ist als die Außenabmessungen des Sensors (4).

6. Einsteckschloss nach einem der vorhergehenden Ansprüche, **dadurch gekennzeichnet, dass** ein Kunststoffhalter (6) vorgesehen ist, mittels welchem der Sensor (4) und/oder der Magnet (1) klemmend mindestens teilweise versenkt in dem Bauteil (2, 3) montierbar ist.

7. Einsteckschloss nach einem der vorhergehenden Ansprüche, **dadurch gekennzeichnet, dass** mehrere Sensoren (4) in geometrischer Reihenanordnung vorgesehen sind zur Erfassung von mehreren möglichen relativen Positionen der Bauteile (2, 3) zueinander.

8. Einsteckschloss nach einem der vorhergehenden Ansprüche, **dadurch gekennzeichnet, dass** der magnetosensitive Sensor (4) ein Hall-Sensor oder ein Reedschalter ist.

9. Einsteckschloss nach einem der vorhergehenden Ansprüche, **dadurch gekennzeichnet, dass** das plattenförmige Bauteil (2, 3) eine elektrische Platine ist, welche oberhalb oder unterhalb von den mechanischen Bauteilen des Schlosses (10) positioniert ist.

10. Einsteckschloss nach Anspruch 9, **dadurch gekennzeichnet, dass** die Platine teilweise freigeschnitten ist und/oder einen Boden oder eine Decke des Schlosses (10) bildet.

11. Einsteckschloss nach einem der vorhergehenden Ansprüche, **dadurch gekennzeichnet, dass** mit dem Sensor (4) die Position des Magneten (1) in der X-, Y- und/oder Z-Ebene erfassbar ist.

## Claims

1. A mortise lock (10) specifically for a door or window, having a means to monitor the relative and/or absolute position of movable components of the lock (10) using at least one first plate-shaped component (2) and at least one second component (3) that can move relative to the first component (2) and that can have different positions depending on the function of the lock (10), whereby the means to monitor the position has at least one magnetosensitive sensor (4), which is installed in one of the components (2, 3) and whose contacts are directly connected to a printed circuit board or a flexible conductor foil, and whereby the sensor (4) cooperates with at least one magnet (1) on the other component (2, 3), which can move relative to the first one, in order to generate a position signal, **characterized in that** the first, plate-shaped component (2) has an opening (5), in which the sensor (4) is flush-mounted, and that the second component (3) has an opening (5), in which the magnet (1) is flush-mounted.

2. The mortise lock as recited in Claim 1, **characterized in that** the plate-shaped component (2) is a printed circuit board, and that the contacts of the sensor (4) are directly connected to the printed circuit board.

3. The mortise lock as recited in any of the preceding claims, **characterized in that** the at least one magnet (1) is flush-embedded in a component (3) of the lock (10) and is arranged so as to be the least possible distance below the plate-shaped component (2), specifically an electrical circuit board.

4. The mortise lock as recited in any of the preceding claims, **characterized in that** the magnetosensitive sensor (4) is designed as an encapsulated sensor featuring SMD construction.

5. The mortise lock as recited in any of the preceding claims, **characterized in that** the plate-shaped component (2) has an opening (5), which is slightly smaller or larger than the exterior dimensions of the sensor (4), for accommodating the sensor (4).

6. The mortise lock as recited in any of the preceding claims, **characterized in that** a plastic holder (6) is provided, which clamps the sensor (4) and/or the magnet (1) in the component (2, 3) so that it is/they are at least partially recessed.

7. The mortise lock as recited in any of the preceding claims, **characterized in that** multiple sensors (4) are provided in a geometrical series arrangement for monitoring the multiple possible relative positions of the components (2, 3) with respect to each other.

8. The mortise lock as recited in any of the preceding claims, **characterized in that** the magnetosensitive sensor (4) is a Hall sensor or a reed switch.

9. The mortise lock as recited in any of the preceding claims, **characterized in that** the plate-shaped component (2, 3) is an electrical circuit board, which is positioned above or below the mechanical components of the lock (10).

10. The mortise lock as recited in Claim 9, **characterized in that** the circuit board is partially cut free and/or constitutes a base or a cover of the lock (10).

11. The mortise lock as recited in any of the preceding claims, **characterized in that** the position of the magnet (1) in the X, Y, and/or Z planes can be detected using the sensor (4).

## Revendications

1. Serrure encastrée (10), en particulier pour une porte ou une fenêtre, munie de moyens de détection de la position relative et/ou absolue de composant mobiles de la serrure (10), avec au moins un premier composant en forme de plaque (2) et au moins un deuxième composant ajustable (3) par rapport au premier composant (2), pouvant prendre des positions différentes selon la fonction de la serrure (10), dans laquelle les moyens de détection de position comprennent au moins un capteur magnéto-sensible (4) disposé dans l'un des composants (2, 3), et dont les contacts sont reliés directement à une carte de circuits imprimés ou à une feuille conductrice, et dans laquelle le capteur (4) coopère avec au moins un aimant (1) situé sur un autre composant (2, 3) mobile à un rapport à ce dernier, afin de générer un signal de position, **caractérisée en ce que** le premier composant en forme de plaque (2) présente une ouverture (5) dans laquelle le capteur (4) est monté de manière encastrée, et **en ce que** le deuxième composant (3) comporte une ouverture (5), dans laquelle l'aimant (1) est monté de manière encastrée.

2. Serrure encastrée selon la revendication 1, **caractérisée en ce que** le composant en forme de plaque (2) est une carte de circuits imprimés, et les contacts du capteur (4) sont reliés directement à la carte de circuits imprimés.

3. Serrure encastrée selon l'une quelconque des revendications précédentes, **caractérisée en ce que** le au moins un aimant (1) est encastré dans un composant (3) du verrou (10), et est agencé avec le plus petit écartement possible au-dessous du composant en forme de plaque (2), en particulier une carte de circuits imprimés électrique.

4. Serrure encastrée selon l'une quelconque des revendications précédentes, **caractérisé en ce que** le capteur magnéto-sensible (4) est réalisé sous forme d'un capteur encapsulé par la technique de fabrication SMD.

5. Serrure encastrée selon l'une quelconque des revendications précédentes, **caractérisée en ce que** le composant en forme de plaque (2) présente une ouverture (5) pour recevoir le capteur (4), qui est légèrement plus petite ou plus grande que les dimensions extérieures du capteur (4).

6. Serrure encastrée selon l'une quelconque des revendications précédentes, **caractérisée en ce qu'**un support en matière plastique (6) est prévu, au moyen duquel le capteur (4) et/ou l'aimant (1) peut être monté par serrage au moins partiellement encastré dans le composant (2, 3).

7. Serrure encastrée selon l'une quelconque des revendications précédentes, **caractérisée en ce que** plusieurs capteurs (4) sont prévus selon un agencement géométrique en série, pour détecter une pluralité de positions relatives possibles des composants (2, 3) les uns par rapport aux autres.

8. Serrure encastrée selon l'une quelconque des revendications précédentes, **caractérisée en ce que** le capteur magnéto-sensible (4) est un capteur à effet Hall ou un commutateur à lames.

9. Serrure encastrée selon l'une quelconque des revendications précédentes, **caractérisée en ce que** le composant en forme de plaque (2, 3) est une carte de circuits imprimés électrique qui est placée au-dessus ou au-dessous des composants mécaniques de la serrure (10).

10. Serrure encastrée selon la revendication 9, **caractérisée en ce que** la carte de circuits imprimés est partiellement découpée et/ou forme un plancher ou un plafond de la serrure (10).

11. Serrure encastrée selon l'une quelconque des revendications précédentes, **caractérisé en ce qu'**à l'aide du capteur (4), la position de l'aimant (1) est détectée dans le plan X, Y et/ou Z.
